# EUROPÄISCHE PATENTSCHRIFT

(11) **EP 4 372 392 B1**
(45) Veröffentlichungstag und Bekanntmachung des Hinweises auf die Patenterteilung: **02.12.2026**
(21) Anmeldenummer: 23202891.0
(22) Anmeldetag: 11.10.2023
(51) Int. Cl.: G01R 27/26, G01R 27/28

(54) **VERFAHREN UND VORRICHTUNG ZUR ERMITTLUNG SEHR KLEINER KAPAZITÄTSÄNDERUNGEN**
METHOD AND DEVICE FOR DETECTING VERY SMALL CAPACITANCE VARIATIONS
PROCÉDÉ ET DISPOSITIF POUR DÉTERMINER DE TRÈS PETITES VARIATIONS DE CAPACITÉ

(30) Priorität: 16.11.2022 DE 102022212172
(43) Veröffentlichungstag der Anmeldung: 22.05.2024
(73) Patentinhaber: Forschungszentrum Jülich GmbH, 52428 Jülich (DE)
(72) Erfinder: Grewing, Christian, 52428 Jülich (DE); van Waasen, Prof. Dr. Stefan, 41836 Hückelhoven (DE); Vliex, Dr.-Ing. Patrick, 52078 Aachen (DE); Bühler, Jonas, 40882 Ratingen (DE)
(74) Vertreter: Gille Hrabal Partnerschaftsgesellschaft mbB Patentanwälte

(56) Entgegenhaltungen:
- WO-A1-2007/034519
- JP-A- H08 278 336
- US-A1- 2010 231 239
- US-A1- 2014 009 176
- US-B1- 11 444 184

## Beschreibung

Die Erfindung betrifft ein Verfahren und eine Vorrichtung zur Ermittlung sehr kleiner Kapazitätsänderungen.

Sehr kleine Kapazitätsänderungen messen zu können ist beispielsweise für ein Auslesen eines Spinzustands eines Elektrons in einem Quantenpunkt von Interesse. Ein Quantenpunkt ist eine nanoskopische Materialstruktur, die aus einem Halbleitermaterial wie z. B. InGaAs, CdSe oder GalnP/InP gebildet sein kann. Ladungsträger (Elektronen, Löcher) in einem Quantenpunkt sind in ihrer Beweglichkeit in allen drei Raumrichtungen so weit eingeschränkt, dass ihre Energie nicht mehr kontinuierliche, sondern nur noch diskrete Werte annehmen kann. Insbesondere ist ein Quantenpunkt von Interesse, in dem ein Elektron nur den Spinzustand -½ und +½ annimmt. In einem Quantencomputer können eine Vielzahl von Quantenpunkten implementiert sein. Eine jedes Elektron eines Quantenpunkts, das nur den Spinzustand -½ und +½ einnehmen kann, übernimmt dann die Rolle einer kleinsten Rechen- und Informationseinheit des Quantencomputers. Eine solche kleinste Rechen- und Informationseinheit wird Qubit genannt. Im Unterschied zu einem herkömmlichen Bit kann ein Qubit mehrere Zustände gleichzeitig annehmen, solange der Zustand des Qubits nicht ausgelesen wird.

Um den Spinzustand eines Elektrons eines Quantenpunkts auszulesen, kann eine quasi-nulldimensionale Halbleiterstruktur benachbart zum Quantenpunkt angeordnet sein. Wird ein Elektron in die quasi-nulldimensionale Halbleiterstruktur verschoben, so kann dadurch der Spinzustand des Elektrons im Quantenpunkt ausgelesen werden. Die dann nebeneinander angeordneten Elektronen befinden sich nämlich entweder im gleichen Spinzustand oder im entgegengesetzten Spinzustand. Befinden sich die Spins der beiden Elektronen im entgegengesetzten Zustand, dann ist der Spinzustand des einen Elektrons -½ und der Spinzustand des anderen Elektrons +½. Befinden sich die Spins der beiden Elektronen im gleichen Zustand, dann sind die Spinzustände der beiden Elektronen entweder -½ oder +½.

Eine Kapazität kann in Abhängigkeit von den vorgenannten beiden Spinzuständen geändert werden. Die Änderung der Kapazität hängt dann davon ab, ob sich die beiden Spins im gleichen Zustand befinden oder im entgegengesetzten Zustand. Eine solche Kapazitätsänderung ist allerdings sehr klein und daher sehr schwierig zu messen.

Die Druckschriften US 2010/231239 A1, US 2014/009176 A1, JP H08 278336 A, WO 2007/034519 A1 und US 11 444 184 B1 offenbaren Techniken im Zusammenhang mit der vorliegenden Erfindung.

Durch die vorliegende Erfindung sollen sehr kleine Kapazitätsänderungen ermittelt werden können. Insbesondere sollen sehr kleine Kapazitätsänderungen so ermittelt werden können, dass ein Spinzustand eines Elektrons eines Quantenpunkts ausgelesen werden kann.

Die Aufgabe der Erfindung wird durch ein Verfahren mit den Merkmalen des ersten Anspruchs und eine Vorrichtung mit den Merkmalen des nebengeordneten Anspruchs gelöst. Die abhängigen Ansprüche betreffen vorteilhafte Ausgestaltungen.

Die Aufgabe der Erfindung wird durch ein Verfahren zur Ermittlung einer Kapazitätsänderung gelöst, indem ein oszillierendes Referenzsignal durch einen ersten elektrischen Schwingkreis und ein Oszillatorsignal durch einen zweiten elektrischen Schwingkreis erzeugt werden. Durch eine Kapazitätsänderung, die weniger als 100 Attofarad oder weniger als 10 Attofarad beträgt, wird die Phase des Oszillatorsignals geändert. Im Anschluss an die Änderung der Phase des Oszillatorsignals wird die dadurch bewirkte Phasenverschiebung zwischen dem Referenzsignal und dem Oszillatorsignal durch einen Phasendetektor ermittelt. Da die ermittelte Phasenverschiebung von der Kapazitätsänderung abhängt, ist die ermittelte Phasenverschiebung ein Maß für die Kapazitätsänderung. Es ist folglich die Änderung der Kapazität ermittelt worden.

Ein elektrischer Schwingkreis ist eine resonanzfähige elektrische Schaltung mit einer Induktivität und einer Kapazität. Der elektrische Schwingkreis kann eine Spule und einen Kondensator als Bauteile umfassen, durch die Induktivität und die Kapazität bereitgestellt werden. Im einfachsten Fall ist ein Anschluss der Spule mit einem Anschluss des Kondensators durch einen ersten elektrischen Leiter verbunden. Der andere Anschluss der Spule ist mit dem anderen Anschluss des Kondensators durch einen zweiten elektrischen Leiter verbunden. Weitere Bauteile oder elektrische Leiter sind in diesem einfachsten Fall nicht vorhanden. Ein solcher Schwingkreis kann durch einen Schaltvorgang oder einen Impuls angeregt werden. Der Schwingkreis führt dann freie Schwingungen aus, die aufgrund von Verlusten nach einer gewissen Zeit abklingen. Um kontinuierlich ein oszillierendes Signal zu erzeugen, kann der Schwingkreis im Bereich seiner Resonanzfrequenz periodisch angeregt werden.

Ein Phasendetektor ist eine Schaltung, die die Phasen eines ersten oszillierenden Signals mit der Phase eines zweiten oszillierenden Signals vergleichen kann. Eine Phasendifferenz kann ein Phasendetektor als Signal ausgeben. Ein Beispiel für einen Phasendetektor ist ein XOR-Gatter. Am Ausgang eines XOR-Gatter entsteht während einer Messung einer Phasenverschiebung eine Pulsspannung, deren Tastverhältnis und damit der arithmetische Mittelwert sich mit der Phasenverschiebung von zwei Eingangsspannungen ändern. Ein anderes Beispiel für einen Phasendetektor ist ein elektrischer Schaltkreis mit zwei Flipflops und einem AND-Gatter.

In einer Ausgestaltung der Erfindung wird das Verfahren mit einer Phasenregelschleife vom Typ 2 durchgeführt. Durch die Phasenregelschleife vom Typ 2 kann das Oszillatorsignal erzeugt werden. Das Referenzsignal kann über einen Eingang der Phasenregelschleife zugeführt werden. Nach einem Einschwingen der Phasenregelschleife kann die Phase des Oszillatorsignals durch die Kapazitätsänderung geändert werden. Eine dadurch dann bewirkte Phasendifferenz zwischen der Phase des Referenzsignals und der Phase des Oszillatorsignals kann durch den Phasendetektor der Phasenregelschleife ermittelt werden.

Vor dem Einschwingen der Phasenregelschleife können die Frequenzen von Referenzsignal und Oszillatorsignal verschieden sein. Durch das Einschwingen wird die Frequenz des Oszillatorsignals geändert und zwar in Abhängigkeit von der Frequenz des Referenzsignals. Nach dem Einschwingen der Phasenregelschleife können die Frequenzen von Referenzsignal und Oszillatorsignal gleich sein. Wird im Anschluss an das Einschwingen die Phase des Oszillatorsignals durch eine Kapazitätsänderung geändert, so ändert sich die Frequenz des Oszillatorsignals nicht. Diese Eigenschaft einer Phasenregelschleife vom Typ 2 trägt dazu bei, dass ein Spinzustand eines Quantenpunkts ausgelesen werden kann und zwar auf technisch besonders einfache Weise.

Die Phasenregelschleife vom Typ 2 kann einen Phasendetektor, eine PLL - Ladungspumpe, ein Filter wie zum Beispiel ein R-C Filter oder ein Loopfilter, und einen Oszillator umfassen. Der Oszillator kann eine Verstärkungsstufe, eine Kapazität und eine Induktivität umfassen. Die Die Phasenregelschleife kann außerdem einen Frequenzteiler aufweisen. Als Verstärkungsstufe kann ein Operationsverstärker dienen. Ein Kondensator kann die Kapazität bereitstellen. Eine Spule kann die Induktivität bereitstellen. Kapazität und Induktivität sind Teil des Schwingkreises zur Erzeugung des Oszillatorsignals.

Eine PLL-Ladungspumpe ist eine bipolar geschaltete Stromquelle. Dies bedeutet, dass positive und negative Stromimpulse in das Schleifenfilter der PLL ausgegeben werden können. Eine PLL-Ladungspumpe kann im Unterschied zu einer Ladungspumpe keine höheren oder niedrigeren Spannungen als seine Strom- und Bodenversorgungspegel erzeugen.

Eine Phasenregelschleife vom Typ 2 kann mehrere Verstärkungsstufen haben. Durch eine Phasenregelschleife vom Typ 2 kann eine Verstärkung von 60 bis 70 dB erreicht werden. Eine Phasenregelschleife vom Typ 2 kann so sein, dass eine Phasenänderung im Picosekundenbereich gemessen werden kann, so zum Beispiel im Bereich von 5 - 10 Picosekunden. Es kann daher eine extrem kleine Kapazitätsänderung mit genügend Verstärkung in eine Phasenänderung umgesetzt werden, so dass die Phasenveränderung messbar ist.

Vorzugsweise wird zwischen dem Referenzsignal und dem Oszillatorsignal ein Phasenunterschied von 180° eingestellt. Erst im Anschluss daran wird die Phase des Oszillatorsignals durch die Kapazitätsänderung geändert. Dies trägt dazu bei, verbessert sehr kleine Kapazitätsänderungen ermitteln zu können.

Vorzugsweise werden ein rechteckiges Referenzsignal und ein rechteckiges Oszillatorsignal erzeugt. Referenzsignal und Oszillatorsignal sind dann also Rechtecksignale. Ein Rechtecksignal ist ein periodisches Signal, das zwischen zwei Werten hin und her schaltet und in einem Diagramm über der Zeit einen rechteckigen Verlauf aufweist. Dies trägt dazu bei, verbessert sehr kleine Kapazitätsänderungen ermitteln zu können. Das gilt vor allem für den Fall, dass zwischen dem Referenzsignal und dem Oszillatorsignal ein Phasenunterschied von 180° eingestellt worden ist, bevor die Phase des Oszillatorsignals durch die Kapazitätsänderung geändert wurde.

Nach der Änderung der Phase des Oszillatorsignals durch die Kapazitätsänderung kann die Phasenverschiebung zwischen dem Referenzsignal und dem Oszillatorsignal mehr als 10 mal oder mehr als 20 mal oder mehr als 50 mal durch den Phasendetektor gemessen werden. Es kann der Mittelwert aus den gemessenen Phasenverschiebungen gebildet werden. Der Mittelwert ist dann ein Maß für die durch die Kapazitätsänderung bewirkte Phasenverschiebung zwischen dem Oszillatorsignal und dem Referenzsignal. Weiter verbessert können so sehr genau und zuverlässig sehr kleine Kapazitätsänderungen ermittelt werden. Insbesondere bei Verwendung einer Phasenregelschleife vom Typ 2 ist dies möglich.

Es kann eine quasi-nulldimensionale Halbleiterstruktur neben einem Quantenpunkt angeordnet sein. In die quasi-nulldimensionale Halbleiterstruktur kann ein Elektron verschoben werden. Die quasi-nulldimensionale Halbleiterstruktur kann mit einem elektrischen Leiter mit dem Schwingkreis, der das Oszillatorsignal erzeugt, so verbunden oder gekoppelt sein, dass durch das Verschieben des Elektrons die Phase des Oszillatorsignals geändert wird. Es kann so ein Qubit eines Quantencomputers ausgelesen werden.

Der Quantenpunkt kann ein Transistor mit einem darin befindlichen Elektron sein. Die quasi-nulldimensionale Halbleiterstruktur kann ein Transistor sein. Es können also zwei Transistoren nebeneinander angeordnet sein. In einem Transistor kann ein als Qubit verwendbares Elektron vorhanden sein, das genau zwei messbare Spinzustände einnehmen kann. Auch der andere Transistor kann so sein, dass ein Elektron im Transistor genau zwei messbare Spinzustände einnehmen kann. In den anderen Transistor kann ein Elektron gebracht werden. Dadurch kann die Kapazitätsänderung bewirkt werden, die die Phase des Oszillatorsignals ändert. Um dies zu erreichen, kann das Gate des anderen Transistors mit dem Schwingkreis elektrisch verbunden oder gekoppelt sein, durch den das Oszillatorsignal erzeugt werden kann.

Eine Spannung, die an dem anderen Transistor anliegt, kann nicht mehr als 100 mV oder nicht mehr als 50 mV oder nicht mehr als 20 mV betragen, um ein Qubit auslesen zu können.

Die Kapazität des Gates des anderen Transistors kann weniger als 1000 Femtofarad oder weniger als 500 Femtofarad betragen, um ein Qubit auslesen zu können.

Es zeigen:
Figur 1: Vorrichtung mit Phasenregelschleife vom Typ 2;
Figur 2: zeitlicher Signalverlauf nach einem Einschwingen;
Figur 3: zeitlicher Signalverlauf mit Signalverschiebung.

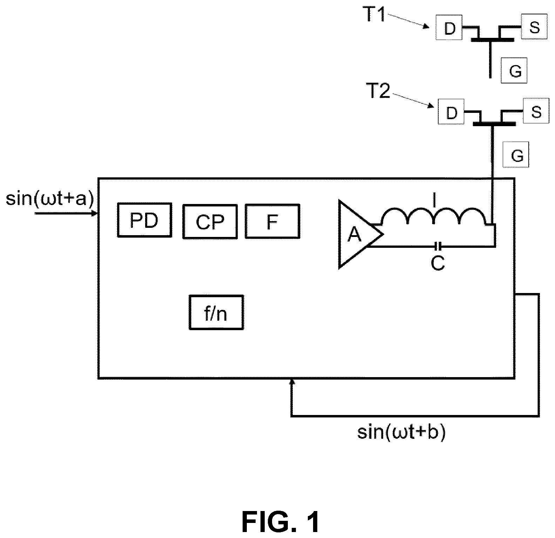

Die Figur 1 zeigt ein Ausführungsbeispiel der Erfindung.

Die Vorrichtung umfasst eine Phasenregelschleife vom Typ 2. Die Phasenregelschleife umfasst einen Phasendetektor PD, eine PLL - Ladungspumpe CP, einen R-C Filter F, einen Frequenzteiler f/n und einen Oszillator. Der Oszillator umfasst eine Verstärkungsstufe A und einen Schwingkreis mit einer Kapazität C und einer Induktivität I. Der Schwingkreis ist mit dem Gate G eines Transistors T2 verbunden. Der Transistor T2 umfasst eine Source S und eine Drain D. Benachbart zum Transistor T2 gibt es einen gleichen Transistor T1. Im Transistor T1 befindet sich ein Elektron, welches ein Qubit repräsentiert.

Die Phasenregelschleife umfasst einen Eingang, in welches während des Betriebs ein oszillierendes Signal sin(ωt+a) eingeleitet wird. ω ist die Kreisfrequenz und damit ein Maß für die Frequenz des eingeleiteten oszillierenden Signals. t ist die Zeit und a die Phase des eingeleiteten oszillierenden Signals. Ein durch den Schwingkreis erzeugtes oszillierendes Signal sin(ωt+b) mit ω = Kreisfrequenz und t = Zeit weist eine Phase b auf. Nach einer Einschwingphase sind die Frequenzen des oszillierenden Signals sin(ωt+a) und des oszillierenden Signals sin(ωt+b) gleich. Wird ein Elektron in den Transistor T2 gebracht, so wird dadurch ein Signal in den Schwingkreis mit der Kapazität C und der Induktivität I eingeleitet, das von den Spinzuständen der Elektronen in den beiden Transistoren T1 und T2 abhängt. Das eingeleitete Signal verändert die Phase b, ohne dass sich die Phase a oder die Kreisfrequenzen ω der beiden Signale sin(ωt+a) und sin(ωt+b) ändern würden. Die dadurch bewirkte Differenz zwischen a und b wird gemessen und so der Spinzustand des Elektrons im Transistor T1 ausgelesen.

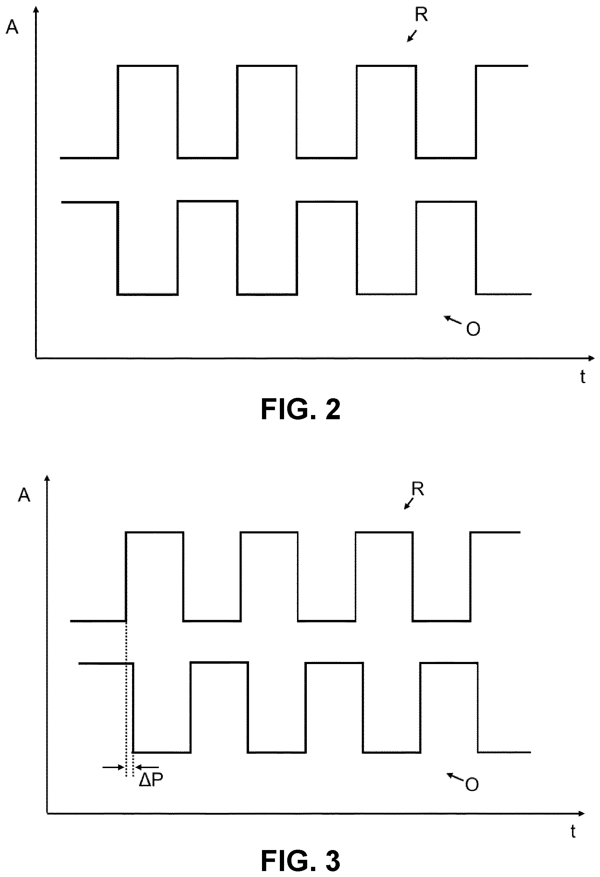

In der Figur 2 wird der zeitliche Verlauf eines Oszillatorsignals O und eines Referenzsignals R im Anschluss an eine Einschwingphase der Phasenregelschleife vom Typ 2 gezeigt. Die Frequenz des Oszillatorsignals O stimmt mit der Frequenz des Referenzsignals R überein. Die Phase des Oszillatorsignals O ist gegenüber der Phase des Referenzsignals R um 180° versetzt. Oszillatorsignal O und Referenzsignal R sind Rechtecksignale.

Wird nun ein Elektron in den Transistor T2 gebracht, so verschiebt sich die Phase des Oszillatorsignals um ΔP. Diese Phasenverschiebung ΔP kann nun u. a. deshalb sehr gut detektiert werden, weil der der dadurch bewirkte Versatz zwischen den praktisch senkrecht ansteigenden bzw. absteigenden Flanken der Rechtecksignale sehr gut detektiert werden kann. Dies wird durch die Figur 3 verdeutlicht.

## Patentansprüche

1. Verfahren zur Ermittlung einer Kapazitätsänderung, wobei ein oszillierendes Referenzsignal (R) und ein oszillierendes Oszillatorsignal (O) durch elektrische Schwingkreise (I, C) erzeugt werden, wobei durch eine Kapazitätsänderung, die weniger als 100 Attofarad oder weniger als 10 Attofarad beträgt, die Phase des Oszillatorsignals (O) geändert wird, wobei im Anschluss an die Änderung der Phase des Oszillatorsignals (O) die dadurch bewirkte Phasenverschiebung (ΔP) zwischen dem Referenzsignal (R) und dem Oszillatorsignal (O) durch einen Phasendetektor (PD) als Maß für die Kapazitätsänderung ermittelt wird, **dadurch gekennzeichnet, dass** zwei Transistoren (T1, T2) nebeneinander angeordnet sind und in einem Transistor (T1) ein als Qubit verwendbares Elektron vorhanden ist, das genau zwei messbare Spinzustände einnehmen kann, und in den anderen Transistor (T2) ein Elektron gebracht wird, das genau zwei messbare Spinzustände einnehmen kann, und dadurch die Kapazitätsänderung (ΔP) bewirkt wird.

2. Verfahren nach dem vorhergehenden Anspruch, **dadurch gekennzeichnet, dass** eine Phasenregelschleife vom Typ 2 für die Durchführung des Verfahrens verwendet wird.

3. Verfahren nach dem vorhergehenden Anspruch, **dadurch gekennzeichnet, dass** durch die Phasenregelschleife das Oszillatorsignal (O) erzeugt wird und nach dem Einschwingen der Phasenregelschleife durch die Kapazitätsänderung die Phase des Oszillatorsignals (O) geändert wird und die dadurch bewirkte Phasenänderung (ΔP) zwischen dem Referenzsignal (R) und dem Oszillatorsignal (O) durch einen Phasendetektor (PD) der Phasenregelschleife ermittelt wird.

4. Verfahren nach einem der beiden vorhergehenden Ansprüche, **dadurch gekennzeichnet, dass** die Phasenregelschleife vom Typ 2 einen Phasendetektor (PD), eine PLL - Ladungspumpe (CP), ein Filter (F), einen Frequenzteiler (1/f) und einen Oszillator umfasst, wobei der Oszillator eine Verstärkungsstufe (A), eine Kapazität (C) und eine Induktivität (I) umfasst.

5. Verfahren nach einem der vorhergehenden Ansprüche, **dadurch gekennzeichnet, dass** zwischen dem Referenzsignal (R) und dem Oszillatorsignal (O) ein Phasenunterschied von 180° eingestellt wird und erst im Anschluss daran die Phase des Oszillatorsignals (O) durch die Kapazitätsänderung geändert wird.

6. Verfahren nach einem der vorhergehenden Ansprüche, **dadurch gekennzeichnet, dass** ein rechteckiges Referenzsignal (R) und ein rechteckiges Oszillatorsignal (O) erzeugt werden.

7. Verfahren nach dem vorhergehenden Anspruch, **dadurch gekennzeichnet, dass** nach der Änderung der Phase des Oszillatorsignals (O) die Phasenverschiebung (ΔP) zwischen dem Referenzsignal (R) und dem Oszillatorsignal (O) mehr als 10 mal durch den Phasendetektor (PD) gemessen wird und der Mittelwert aus den gemessenen Phasenverschiebungen (ΔP) gebildet wird, um so die bewirkte Phasenverschiebung (ΔP) zu ermitteln.

8. Verfahren nach dem vorhergehenden Anspruch, **dadurch gekennzeichnet, dass** eine Spannung an dem anderen Transistor anliegt (T2), die nicht mehr als 100 mV oder nicht mehr als 50 mV oder nicht mehr als 20 mV beträgt.

9. Verfahren nach einem der beiden vorhergehenden Ansprüche, **dadurch gekennzeichnet, dass** das Gate (G) des anderen Transistors (T2) mit dem Schwingkreis (I, C) durch einen elektrischen Leiter verbunden ist, durch den das Oszillatorsignal (O) erzeugt wird.

10. Verfahren nach einem der drei vorhergehenden Ansprüche, **dadurch gekennzeichnet, dass** die Kapazität des Gates des anderen Transistors (T2) weniger als 1000 Femtofarad oder weniger als 500 Femtofarad beträgt.

11. Vorrichtung zur Durchführung eines Verfahrens nach einem der vorhergehenden Ansprüche mit einer Phasenregelschleife vom Typ 2 umfassend einen elektrischen Schwingkreis (I, C) zur Erzeugung eines Oszillatorsignals (O), **gekennzeichnet durch** einen Quantenpunkt, eine quasi-nulldimensionale Halbleiterstruktur neben dem Quantenpunkt, mit einer elektrischen Verbindung oder Kopplung zwischen der quasinulldimensionalen Halbleiterstruktur und dem Schwingkreis (I, C), wobei der Quantenpunkt einen Transistor (T1) umfasst und die quasi-nulldimensionale Halbleiterstruktur einen Transistor (T2) umfasst.

12. Vorrichtung nach dem vorhergehenden Anspruch, **dadurch gekennzeichnet, dass** ein Schwingkreis zur Erzeugung eines Referenzsignals (R) vorhanden ist, der mit einem Eingang der Phasenregelschleife verbunden ist.

13. Vorrichtung nach einem der beiden vorhergehenden Ansprüche, **dadurch gekennzeichnet, dass** eine Einrichtung vorhanden ist, mit der ein Elektron in die quasinulldimensionalen Halbleiterstruktur (T2) gebracht werden kann.

## Claims

1. Method for determining a capacitance change, wherein an oscillating reference signal (R) and an oscillating oscillator signal (O) are generated by electrical resonant circuits (I, C), wherein a phase of the oscillator signal (O) is changed by a capacitance change that amounts to less than 100 attofarads or less than 10 attofarads, wherein following the change of the phase of the oscillator signal (O), the phase shift (ΔP) caused thereby between the reference signal (R) and the oscillator signal (O) is determined by a phase detector (PD) as a measure for the capacitance change, **characterized in that** two transistors (T1, T2) are arranged next to each other and in one transistor (T1) an electron usable as a qubit is present that can assume exactly two measurable spin states, and an electron that can assume exactly two measurable spin states is brought into the other transistor (T2), and thereby the capacitance change (ΔP) is caused.

2. Method according to the preceding claim, **characterized in that** a type 2 phase-locked loop is used for carrying out the method.

3. Method according to the preceding claim, **characterized in that** the oscillator signal (O) is generated by the phase-locked loop and after the settling of the phase-locked loop, the phase of the oscillator signal (O) is changed by the capacitance change and the phase change (ΔP) caused thereby between the reference signal (R) and the oscillator signal (O) is determined by a phase detector (PD) of the phase-locked loop.

4. Method according to one of the two preceding claims, **characterized in that** the type 2 phase-locked loop comprises a phase detector (PD), a PLL charge pump (CP), a filter (F), a frequency divider (1/f) and an oscillator, wherein the oscillator comprises an amplification stage (A), a capacitance (C) and an inductance (I).

5. Method according to one of the preceding claims, **characterized in that** a phase difference of 180° is set between the reference signal (R) and the oscillator signal (O) and only thereafter is the phase of the oscillator signal (O) changed by the capacitance change.

6. Method according to one of the preceding claims, **characterized in that** a rectangular reference signal (R) and a rectangular oscillator signal (O) are generated.

7. Method according to the preceding claim, **characterized in that** after the change of the phase of the oscillator signal (O), the phase shift (ΔP) between the reference signal (R) and the oscillator signal (O) is measured more than 10 times by the phase detector (PD) and the mean value of the measured phase shifts (ΔP) is formed in order to determine the caused phase shift (ΔP).

8. Method according to the preceding claim, **characterized in that** a voltage is applied to the other transistor (T2) that amounts to not more than 100 mV or not more than 50 mV or not more than 20 mV.

9. Method according to one of the two preceding claims, **characterized in that** the gate (G) of the other transistor (T2) is connected by an electrical conductor to the resonant circuit (I, C) by which the oscillator signal (O) is generated.

10. Method according to one of the three preceding claims, **characterized in that** the capacitance of the gate of the other transistor (T2) amounts to less than 1000 femtofarads or less than 500 femtofarads.

11. Device for carrying out a method according to one of the preceding claims with a type 2 phase-locked loop comprising an electrical resonant circuit (I, C) for generating an oscillator signal (O), **characterized by** a quantum dot, a quasi-zero-dimensional semiconductor structure next to the quantum dot, with an electrical connection or coupling between the quasi-zero-dimensional semiconductor structure and the resonant circuit (I, C), wherein the quantum dot comprises a transistor (T1) and the quasi-zero-dimensional semiconductor structure comprises a transistor (T2).

12. Device according to the preceding claim, **characterized in that** a resonant circuit for generating a reference signal (R) is present that is connected to an input of the phase-locked loop.

13. Device according to one of the two preceding claims, **characterized in that** a device is present with which an electron can be brought into the quasi-zero-dimensional semiconductor structure (T2).

## Revendications

1. Procédé de détection d'une variation de capacité, dans lequel un signal de référence oscillant (R) et un signal d'oscillateur oscillant (O) sont générés par des circuits oscillants électriques (I, C), une variation de capacité inférieure à 100 attofarads ou inférieure à 10 attofarads modifie la phase du signal d'oscillateur (O), le déphasage (ΔP) ainsi provoqué entre le signal de référence (R) et le signal d'oscillateur (O), à la suite de la modification de la phase du signal d'oscillateur (O), étant déterminé par un détecteur de phase (PD) comme mesure de la variation de capacité, **caractérisé en ce que** deux transistors (T1, T2) sont disposés côte à côte et qu'un électron pouvant servir de qubit, capable de prendre exactement deux états de spin mesurables, est présent dans un transistor (T1), tandis qu'un électron capable de prendre exactement deux états de spin mesurables est introduit dans l'autre transistor (T2), ce qui provoque la variation de capacité (ΔP).

2. Procédé selon la revendication précédente, **caractérisé en ce qu'**une boucle à verrouillage de phase de type 2 est utilisée pour la mise en œuvre du procédé.

3. Procédé selon la revendication précédente, **caractérisé en ce que** le signal d'oscillateur (O) est généré par la boucle à verrouillage de phase et, une fois que la boucle à verrouillage de phase s'est stabilisée, la phase du signal d'oscillateur (O) est modifiée par la variation de capacité, et la variation de phase (ΔP) ainsi provoquée entre le signal de référence (R) et le signal d'oscillateur (O) est déterminée par un détecteur de phase (PD) de la boucle à verrouillage de phase.

4. Procédé selon l'une des deux revendications précédentes, **caractérisé en ce que** la boucle à verrouillage de phase de type 2 comprend un détecteur de phase (PD), une PLL - pompe de charge (CP), un filtre (F), un diviseur de fréquence (1/f) et un oscillateur, l'oscillateur comprenant un étage d'amplification (A), une capacité (C) et une inductance (I).

5. Procédé selon l'une des revendications précédentes, **caractérisé en ce qu'**une différence de phase de 180° est établie entre le signal de référence (R) et le signal d'oscillateur (O) et ce n'est qu'ensuite que la phase du signal d'oscillateur (O) est modifiée par la variation de capacité.

6. Procédé selon l'une des revendications précédentes, **caractérisé en ce qu'**un signal de référence rectangulaire (R) et un signal d'oscillateur rectangulaire (O) sont générés.

7. Procédé selon la revendication précédente, **caractérisé en ce qu'**après la modification de la phase du signal d'oscillateur (O), le déphasage (ΔP) entre le signal de référence (R) et le signal d'oscillateur (O) est mesuré plus de 10 fois par le détecteur de phase (PD) et que la moyenne des déphasages mesurés (ΔP) est calculée afin de déterminer le déphasage induit (ΔP).

8. Procédé selon la revendication précédente, **caractérisé en ce qu'**une tension est appliquée à l'autre transistor (T2), qui ne dépasse pas 100 mV, ni 50 mV, ni 20 mV.

9. Procédé selon l'une des deux revendications précédentes, **caractérisé en ce que** la grille (G) de l'autre transistor (T2) est reliée au circuit oscillant (I, C) par un conducteur électrique à travers lequel est généré le signal d'oscillateur (O).

10. Procédé selon l'une des trois revendications précédentes, **caractérisé en ce que** la capacité de la grille de l'autre transistor (T2) est inférieure à 1 000 femtofarads ou inférieure à 500 femtofarads.

11. Dispositif destiné à la mise en œuvre d'un procédé selon l'une des revendications précédentes, comprenant une boucle à verrouillage de phase de type 2 comportant un circuit oscillant électrique (I, C) destiné à générer un signal d'oscillateur (O), **caractérisé par** un point quantique, une structure semi-conductrice quasi-zéro-dimensionnelle adjacente au point quantique, avec une connexion ou un couplage électrique entre la structure semi-conductrice quasi-zéro-dimensionnelle et le circuit oscillant (I, C), le point quantique comprenant un transistor (T1) et la structure semi-conductrice quasi-zéro-dimensionnelle comprenant un transistor (T2).

12. Dispositif selon la revendication précédente, **caractérisé en ce qu'**il comprend un circuit oscillant destiné à générer un signal de référence (R), qui est relié à une entrée de la boucle à verrouillage de phase.

13. Dispositif selon l'une des deux revendications précédentes, **caractérisé en ce qu'**il comprend un moyen permettant d'introduire un électron dans la structure semi-conductrice quasi-zéro-dimensionnelle (T2).
